Europäisches Patentamt

(19) European Patent Office

Office européen des brevets

(11) Veröffentlichungsnummer: **0 053 709**
**B1**

(12) **EUROPÄISCHE PATENTSCHRIFT**

(45) Veröffentlichungstag der Patentschrift:
06.03.85

(51) Int. Cl.⁴: **H 03 K 17/687,** H 02 M 1/08

(21) Anmeldenummer: **81109050.5**

(22) Anmeldetag: 27.10.81

(54) Schaltungsanordnung zum Ansteuern mindestens eines Leistungs-FET.

(30) Priorität: 04.12.80 DE 3045771
29.05.81 DE 3121508

(43) Veröffentlichungstag der Anmeldung:
16.06.82 Patentblatt 82/24

(45) Bekanntmachung des Hinweises auf die Patenterteilung:
06.03.85 Patentblatt 85/10

(84) Benannte Vertragsstaaten:
AT CH DE FR GB LI SE

(56) Entgegenhaltungen:
DE - B - 1 591 820
US - A - 3 710 147
US - A - 3 805 094

Patent Abstracts of Japan Band 4, Nr. 28, 8. März 1980, Seite 87E1
Patent Abstracts of Japan Band 5, Nr. 63, 28. April 1981, Seite 12E54
SIEMENS COMPONENTS, Band 18, Heft 4, 1980, H. RABL "SIPMOS-Leistungsschalter mit galvanisch getrennter Ansteuerung", Seiten 187, 188
SIEMENS RESEARCH & DEVELOPMENT REPORTS, Band 9, Nr. 4, 1980 Berlin E. HEBENSTREIT "Driving the SIPMOS Field-Effect Translator as a Fast Power Switch", Seiten 200 bis 204

(73) Patentinhaber: Siemens Aktiengesellschaft, Berlin und München Wittelsbacherplatz 2, D-8000 München 2 (DE)

(72) Erfinder: Hebenstreit, Ernst, Dipl. Ing., Am Blütenanger 14, D-8000 München 50 (DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung bezieht sich auf eine Schaltungsanordnung zum Ansteuern mindestens eines Leistungs-FET mit einem Übertrager, dessen Primärwicklung mit einem Steuereingang verbunden ist, mit einem eine Diode aufweisenden Schalter zwischen der Sekundärwicklung und dem Gateanschluß des FET, der bei einem sekundärseitigen Signal der ersten Polarität unter Durchlässigwerden der Diode den Gateanschluß des FET mit einer der Klemmen der Sekundärwicklung verbindet und der bei einem sekundärseitigen Signal der zweiten Polarität den Gateanschluß mit dem Sourceanschluß des FET verbindet.

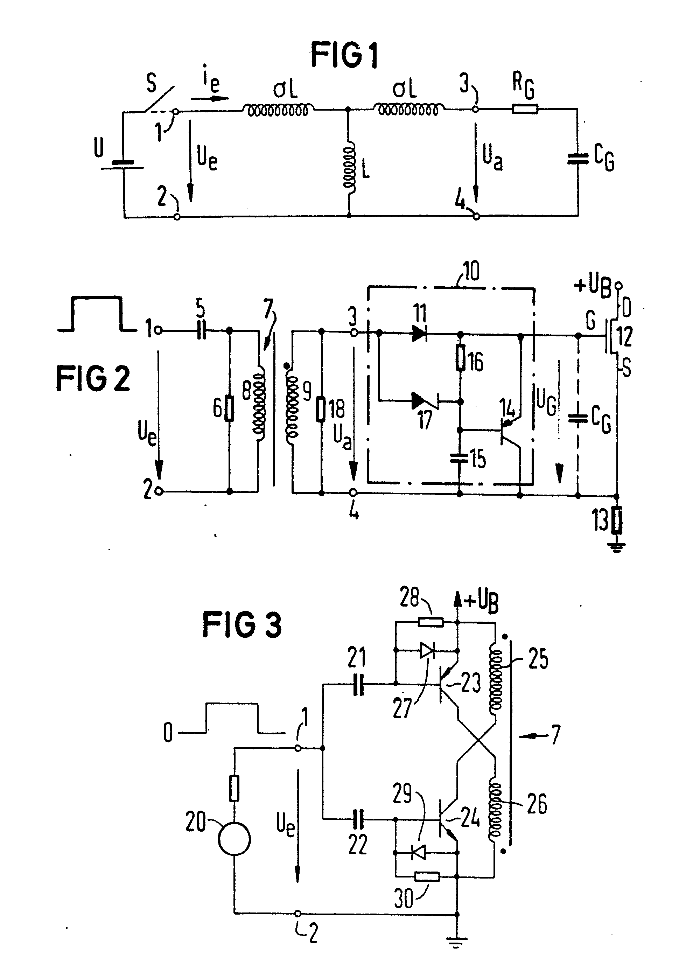

Eine solche Schaltungsanordnung ist zum Beispiel aus den »Patent Abstracts of Japan«, Band 4, Nr. 28, 8. März 1980, Seite 87 E1, Zusammenfassung von JP 55-1756 bekanntgeworden. Die Schaltungsanordnung wird dadurch angesteuert, daß an eine Primärwicklung des Übertragers eine Gleichspannungsquelle über einen Schalter impulsweise angeschaltet wird. Der Primärwicklung des Übertragers werden Rechteckimpulse zugeführt. Die positiven Flanken der Rechteckimpulse schalten den FET über eine Diode ein, während die negativen Flanken einen zwischen Gateanschluß und Sourceanschluß des FET liegenden Transistor leitend schalten, so daß der FET gesperrt wird. Bei einer Übertragerankopplung ergibt sich dabei jedoch folgendes Problem, das im Zusammenhang mit Fig. 1 dargestellt wird:

In Fig. 1 ist ein Ersatzschaltbild eines Übertragers dargestellt. Dieser ist charakterisiert durch die primäre und die sekundäre Streuinduktivität $\sigma\,L$ und die Querinduktivität L. Wird an die Eingangsklemmen 1, 2 durch Schließen des Schalters S eine Eingangsspannung $u_e$ zugeführt, so fließt ein Strom $i_e$, der sekundärseitig eine Spannung $u_a$ induziert, die an den Ausgangsklemmen 3, 4 ansteht. Diese Spannung ist die Steuerspannung des Leistungs-FET, der durch den Widerstand $R_G$ und die Eingangskapazität $C_G$ symbolisiert ist. Ist die Eingangskapazität $C_G$ aufgeladen, so fließt der Strom $i_e$ durch die primäre Streuinduktivität $\sigma\,L$ und die Querinduktivität L als Magnetisierungsstrom

$$i_e = \frac{1}{L\,(1+\sigma)} \cdot U \cdot t$$

weiter. Der Magnetisierungsstrom $i_e$ ist also der auf den Anschaltzeitpunkt der Spannung U bezogenen Zeit t proportional. Der Magnetisierungsstrom verursacht im Übertrager entsprechende Verluste. Außerdem entstehen Probleme, die im Übertrager aufgebaute magnetische Energie zu beseitigen.

Der Erfindung liegt die Aufgabe zugrunde, eine Schaltungsanordnung der obengenannten Art so weiterzubilden, daß sowohl ein gesteuertes Einschalten als auch ein gesteuertes Ausschalten des Leistungs-FET möglich ist, daß dabei aber die im Übertrager umgesetzte Verlustleistung möglichst klein bleibt.

Diese Aufgabe wird dadurch gelöst, daß zwischen Steuereingang und Primärwicklung ein Differenzierglied liegt.

Weiterbildungen der Erfindung sind Gegenstand der abhängigen Patentansprüche. Die Erfindung wird an Hand von Ausführungsbeispielen in Verbindung mit den Fig. 2 bis 6 näher erläutert. Es zeigt

Fig. 2 ein erstes Ausführungsbeispiel der Schaltungsanordnung,

Fig. 3 eine Abwandlung des primärseitig liegenden Differenziergliedes,

Fig. 4 den sekundärseitigen Teil eines zweiten Ausführungsbeispiels,

Fig. 5 einen Umschalter, bei dem sekundärseitig die Anordnungen nach Fig. 2 oder 4 verwendet werden können und

Fig. 6 eine Schaltungsanordnung zum Ansteuern von hintereinandergeschalteten, als Sourcefolger betriebenen FET.

In Fig. 2 ist eine Schaltungsanordnung zum Ansteuern eines Leistungs-FET gezeigt, die aus einem Übertrager 7 mit einer Primärwicklung 8 und einer Sekundärwicklung 9, einem primärseitigen Differenzierglied und einem sekundärseitigen Schalter 10 besteht. Das primärseitige Differenzierglied besteht im einfachsten Fall aus einem im Strompfad liegenden Kondensator 5 und einem Widerstand 6, der der Primärwicklung 8 parallelgeschaltet ist. Eine Klemme 3 der Sekundärwicklung 9 ist über eine Diode 11 mit dem Gateanschluß G eines n-Kanal-Leistungs-FET 12 verbunden. Die andere Klemme 4 der Sekundärwicklung ist mit dem Sourceanschluß S verbunden. Der FET 12 liegt über eine Last 13 an einer Spannung $U_B$. Die Eingangskapazität $C_G$ des FET 12 ist durch einen Kondensator dargestellt, dessen Zuleitungen gestrichelt sind. Zwischen dem Gateanschluß G und dem Sourceanschluß S beziehungsweise parallel zur Eingangskapazität $C_G$ liegt die Laststrecke (Emitter-Kollektorstrecke) eines bipolaren Transistors 14. Der Basis-Emitterstrecke des Transistors 14 ist ein Kondensator 15 parallel geschaltet, dessen einer Anschluß an der Klemme 4 der Sekundärwicklung 9 beziehungsweise am Sourceanschluß S liegt. Der andere, mit dem Basisanschluß des Transistors 14 verbundene Anschluß des Kondensators 15 ist über eine Zenerdiode 17 mit der einen Klemme 3 verbunden. Ferner ist noch ein Widerstand 16 vorgesehen, der zwischen dem Gateanschluß G und dem Basisanschluß des Transistors 14 liegt. Der Bipolartransistor 14 kann auch durch einen p-Kanal-FET ersetzt werden. Bei diesem ist die Laststrecke durch die Strecke Sourcezone—Drainzone gebildet.

Bei Anlegen einer Eingangsspannung $u_e$, zum Beispiel eines Rechteckimpulses, an die Eingangsklemmen 1, 2 wird diese differenziert und erscheint sekundärseitig an den Klemmen 3, 4 als Ausgangsspannung $u_a$ in Form eines positiven und eines negativen Impulses. Der positive Impuls gelangt über die Diode 11 zum Gateanschluß G und lädt die Eingangskapazität $C_G$ auf. Der FET 12 ist damit eingeschaltet. Gleichzeitig wird der Kondensator 15 über die Zenerdiode 17 aufgeladen. Danach nimmt die Spannung an der Sekundärwicklung 9 ab und wird wegen des Abbaus der magnetischen Energie im Übertrager negativ. Diese negative Spannung treibt einen Strom durch den Widerstand 18. Sie ist wesentlich kleiner als die Spannung $u_a$. Erreicht das Potential an der Klemme 3 jedoch einen Wert, bei dem die Differenz zwischen der Spannung $u_G$ an der Kapazität $C_G$ und der erwähnten negativen Spannung größer ist als die Zenerspannung der Zenerdiode 17, so bricht diese durch und entlädt die Eingangskapazität $C_G$ so lange, bis die Spannungsdifferenz kleiner als die Zenerspannung geworden ist. Bei entsprechender Wahl der Zenerspannung entlädt sich die Eingangskapazität $C_G$ nur so weit, daß der FET 12 leitend bleibt.

Wird die Eingangsspannung $u_e$ unterbrochen, so erscheint an den Ausgangsklemmen 3, 4 ein negativer Impuls. Dieser Impuls hat die Größe $-u_a$, so daß nun an der Klemme 3 eine Spannung liegt, die der Summe der Spannungen $u_a + u_G$ entspricht. Hierbei bricht die Zenerdiode 17 durch, der Kondensator 15 entlädt sich und der Transistor 14 wird geöffnet. Nun wird die Eingangskapazität $C_G$ entladen und der FET 12 sperrt. Nach dem Abklingen des negativen Impulses an den Klemmen 3, 4 entsteht ein positiver Impuls, der wieder auf den Abbau der magnetischen Energie im Übertrager 7 zurückzuführen ist. Dieser Impuls hat geringe Amplitude und wird durch den Widerstand 18 bedämpft. Durch entsprechende Dimensionierung kann er soweit bedämpft werden, daß er kleiner als die Schwellspannungen der Diode 11 und der Zenerdiode 17 ist. Damit kann die Eingangskapazität nicht mehr aufgeladen werden und ein erneutes Einschalten des FET 12 ist ausgeschlossen.

Anstelle des einfachen Differenziergliedes nach Fig. 2 kann eine primärseitige Treiberstufe nach Fig. 3 treten. Zu diesem Zweck ist die Primärwicklung 8 in zwei Teilwicklungen 25, 26 aufgeteilt. In Reihe mit der Teilwicklung 25 liegt die Emitter-Kollektorstrecke eines ersten (pnp) Transistors 24. In Reihe mit der zweiten Teilwicklung 26 liegt die Emitter-Kollektorstrecke eines zweiten (npn) Transistors 23. Die Basisanschlüsse der Transistoren 23, 24 sind über Kondensatoren 21 beziehungsweise 22 mit der Eingangsklemme 1 verbunden. Der Emitteranschluß des pnp-Transistors 23 und der durch einen Punkt gekennzeichnete Anfang der Teilwicklung 25 liegen an der positiven Klemme einer Betriebsspannung $U_B$, während der Emitter des npn-Transistors 24 und der durch einen Punkt gekennzeichnete Anfang der zweiten Teilwicklung 26 an Masse liegen. Die zweite Eingangsklemme 2 liegt ebenfalls an Masse. Mit den Eingangsklemmen 1 und 2 ist eine zum Beispiel Rechteckimpulse liefernde Spannungsquelle 20 verbunden. Zur Vermeidung von Richteffekten ist der Emitter-Basisstrecke des Transistors 23 eine Diode 27 antiparallel und ein Widerstand 28 parallel geschaltet. Entsprechend ist der Transistor 24 mit einer Diode 29 und einem Widerstand 30 beschaltet. Der Transistor 23 kann auch durch einen p-Kanal-FET und der Transistor 24 durch einen n-Kanal-FET ersetzt werden.

Wird auf die Eingangsklemmen 1, 2 die Eingangsspannung $u_e$ gegeben, so wird diese am Kondensator 22 differenziert und öffnet den Transistor 24. Damit fließt ein Strom von $+U_B$ durch die erste Teilwicklung 25 und die Kollektor-Emitterstrecke des Transistors 24 nach Masse. In der Sekundärwicklung 9 (Fig. 2) des Übertragers 7 wird damit ein positiver Impuls induziert, der den FET 12 auf die in Verbindung mit Fig. 2 beschriebene Weise öffnet. Wird die Eingangsspannung unterbrochen, so wird ihre abfallende Flanke im Kondensator 21 differenziert und öffnet den Transistor 23. Damit fließt ein Strom von $+U_B$ durch den Transistor 23 und die zweite Teilwicklung 26 nach Masse. In der Sekundärwicklung 9 wird somit ein negativer Impuls induziert, der auf die beschriebene Weise den FET 12 ausschaltet.

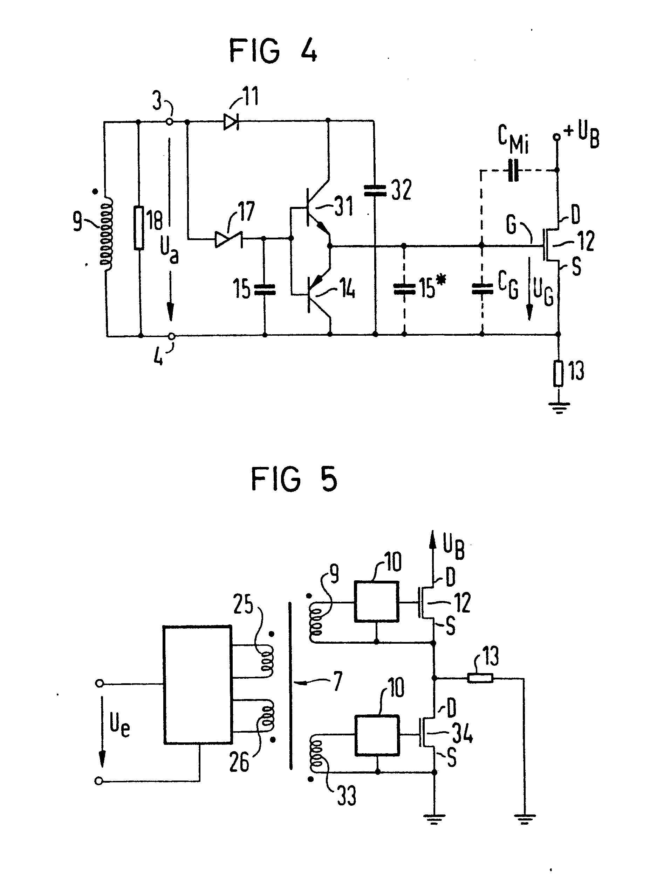

Der Schalter 10 kann dahingehend abgeändert werden, daß zwischen der Diode 11 und dem Gateanschluß des FET 12 die Kollektor-Emitterstrecke eines weiteren Transistors 31 eingeschaltet ist (Fig. 4). Dieser ist ein npn-Transistor und ist mit dem pnp-Transistor 14 zu einem Komplementär-Emitterfolger zusammengeschaltet. Parallel zu den Kollektor-Emitterstrecken der Transistoren 31 und 14 ist ein Kondensator 32 geschaltet. Diese Schaltung hat insbesondere dann einen Vorteil, wenn über die zwischen Drainanschluß D und Gateanschluß G liegende Millerkapazität $C_{Mi}$ positive und negative durch hohe du/dt-Beanspruchungen verursachte Störimpulse auf den Gateanschluß des FET 12 gelangen. Sind diese Störungen groß genug, so könnten sie den FET 12 unabhängig vom Anlegen einer Eingangsspannung aus- oder einschalten. Gelangt nun ein positiver Störimpuls über die Millerkapazität auf den Gateanschluß G, so wird der Transistor 14 ein wenig aufgesteuert und der Störimpuls wird über den Kondensator 15 kurzgeschlossen. Bei einem negativen Störimpuls wird der Transistor 31 aufgesteuert und der Störimpuls wird ebenfalls über den Kondensator 15 kurzgeschlossen. Besonders vorteilhaft ist dabei, daß der Kondensator 15 so wirkt, als läge unmittelbar zwischen Gateanschluß G und Sourceanschluß S ein um die Stromverstärkung $\beta$ des Komplementär-Emitterfolgers vergrößerter Kondensator 15*. Der Kondensator 32 dient dazu, die Versorgungsspannung für den Komplementär-Emitterfolger zu liefern. Er wird bei jedem positiven Stromimpuls über die Diode 11 aufgeladen. An die Stelle des Komplementär-Emitterfolgers kann auch ein aus einem n-Kanal-FET und einem p-Kanal-FET bestehender Komplementär-Sourcefolger treten.

Auf der Basis der Schaltungen nach Fig. 2, 3 oder 4 läßt sich auch ein in Fig. 5 dargestellter Umschalter aufbauen. Der Umschalter kann einen Schalter 10 nach Fig. 2 oder nach Fig. 4 enthalten. In Serie mit dem FET 12 liegt ein zweiter FET 34, wobei der Sourceanschluß des FET 12 mit dem Drainanschluß des FET 34 verbunden ist. Die Last 13 liegt auf der einen Seite an Masse und auf der anderen Seite am Verbindungspunkt der FET 12 und 34. Der Übertrager 7 liefert sekundärseitig beim Anlegen einer Eingangsspannung an der Sekundärwicklung 9 einen positiven Impuls und an der Sekundärwicklung 33 einen negativen Impuls. Und damit wird der FET 12 eingeschaltet und der FET 34 ausgeschaltet, sofern er nicht bereits gesperrt war. Beim Ausschalten der Eingangsspannung $u_e$ liefert die Sekundärwicklung 9 einen negativen Impuls und die Sekundärwicklung 33 einen positiven Impuls, wodurch der FET 12 gesperrt wird und der FET 34 leitend wird. Die Stromrichtung durch die Last 13 kehrt sich dann um.

Die gezeigten Anordnungen nach den Fig. 2, 3 und 4 können auch dazu verwendet werden, den FET 12 dauernd eingeschaltet zu halten. Dazu wird auf die Eingangsklemmen 1, 2 eine periodische Folge von Rechteckimpulsen der Größe $u_e$ gegeben. Die abfallenden Flanken beziehungsweise die negativen Impulse werden dadurch wirkungslos gemacht, daß entweder die Basiszuleitung zum Transistor 23 durch einen Schalter unterbrochen wird oder daß die Basis-Emitterstrecke kurzgeschlossen wird. Es ist auch möglich, den Stromweg durch die Teilwicklung 26 zu unterbrechen oder die Rückflanke der Eingangsspannung so abzuflachen, daß der Verschiebungsstrom durch den Kondensator 21 nicht ausreicht, um den Transistor 23 zu öffnen.

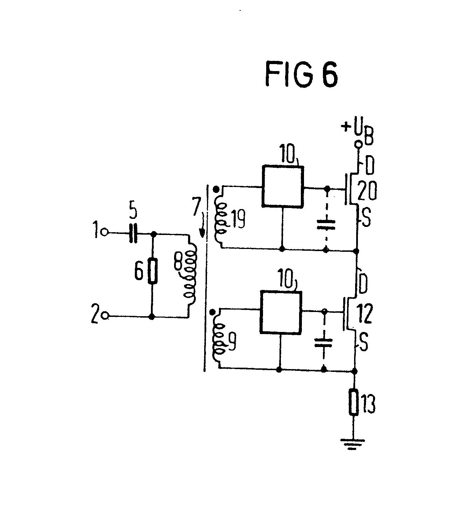

In Fig. 6 ist eine Schaltungsanordnung zum potentialfreien Ansteuern von zwei in Reihe geschalteten, als Sourcefolger betriebenen Leistungs-FET gezeigt. Der Übertrager 7 ist hier entsprechend der Anzahl der in Reihe geschalteten Leistungs-FET 12 und 20 mit zwei gleichsinnig gewickelten Sekundärwicklungen 9 und 19 versehen. Bei Anlegen eines positiven Steuerimpulses an die Klemmen 1, 2 werden in den Sekundärwicklungen 9 und 19 zunächst positive Steuerimpulse erzeugt, die über die Schalter 10 auf die in Verbindung mit Fig. 1 beschriebene Weise die Leistungs-FET 12 und 20 gleichzeitig leitend steuern. Damit liegt die Last 13 an Spannung. Mit der negativen Flanke des Eingangsimpulses werden in beiden Sekundärwicklungen negative Impulse erzeugt, die gleichzeitig die Eingangskapazitäten der Leistungs-FET 12 und 20 entladen und die FET damit sperren.

Eine Erweiterung der Schaltungsanordnung nach Fig. 6 auf mehr als zwei hintereinandergeschaltete FET ist möglich. Dazu ist der Übertrager 7 mit weiteren Sekundärwicklungen zu versehen, die über je einen separaten Schalter 10 auf die in Verbindung mit Fig. 2 beschriebene Weise mit dem Gateanschluß und dem Sourceanschluß der weiteren Leistungs-FET verbunden werden. Damit ist eine potentialfreie, gleichzeitige Ansteuerung aller FET möglich.

Der Vorteil der Reihenschaltung von Leistungs-FET liegt darin, daß sich die maximale Sperrspannung gegenüber einem einzigen Leistungs-FET vervielfacht. Es ist zwar möglich, Leistungs-FET für hohe Sperrspannungen $V_{DS}$ zu konzipieren. Diese FET haben jedoch einen hohen Durchlaßwiderstand im eingeschalteten Zustand ($R_{DS\,ON}$), da dieser proportional zu $V_{DS}^{2,5}$ steigt. Mit der Schaltung gemäß der Erfindung läßt sich also eine Vervielfachung der Sperrspannung bei einer der Anzahl der FET lediglich proportionalen Erhöhung des Durchlaßwiderstands erreichen.

## Patentansprüche

1. Schaltungsanordnung zum Ansteuern mindestens eines Leistungs-FET (12) mit einem Übertrager (7), dessen Primärwicklung (8) mit einem Steuereingang (1, 2) verbunden ist, mit einem eine Diode (11) aufweisenden Schalter (10) zwischen der Sekundärwicklung (9) und dem Gateanschluß des FET, der bei einem sekundärseitigen Signal der ersten Polarität unter Durchlässigwerden der Diode den Gateanschluß des FET (12) mit einer der Klemmen (3) der Sekundärwicklung (9) verbindet und der bei einem sekundärseitigen Signal der zweiten Polarität den Gateanschluß mit dem Sourceanschluß des FET verbindet, dadurch gekennzeichnet, daß zwischen Steuereingang (1, 2) und Primärwicklung (8) ein Differenzierglied (5, 6) liegt.

2. Schaltungsanordnung nach Anspruch 1, dadurch gekennzeichnet, daß der Schalter (10) einen ersten Transistor (14) enthält, dessen Laststrecke in an sich bekannter Weise zwischen Gateanschluß und Sourceanschluß des FET (12) liegt, daß der Schalter einen Kondensator (15) enthält, dessen einer Anschluß mit dem Sourceanschluß des FET und dessen anderer Anschluß mit dem Steueranschluß des ersten Transistors (14) verbunden ist, daß die eine Klemme (3) der Sekundärwicklung (9) über die Diode (11) mit dem Gateanschluß und über eine Zenerdiode (17) mit dem Steueranschluß des ersten Transistors (14) verbunden ist, und daß die Zenerdiode (17) so gepolt ist, daß sie für das sekundärseitige Signal der ersten Polarität durchlässig ist.

3. Schaltungsanordnung nach Anspruch 2, dadurch gekennzeichnet, daß der Schalter einen weiteren, zum ersten Transistor (14) komplementären Transistor (31) enthält, daß die Laststrecke des komplementären Transistors (31) zwischen Diode (11) und Gateanschluß des FET liegt und der Laststrecke des ersten Transistors (14) in Reihe geschaltet ist, daß die Steueranschlüsse beider Transistoren miteinander verbunden sind, und daß ein weiterer Kondensator (32) vorgesehen ist, der den in Reihe geschalteten Laststrecken der Transistoren parallel geschaltet ist.

4. Schaltungsanordnung nach Anspruch 2, dadurch gekennzeichnet, daß der erste Transistor (14) ein Bipolartransistor ist.

5. Schaltungsanordnung nach Anspruch 2, dadurch gekennzeichnet, daß der erste Transistor ein FET ist.

6. Schaltungsanordnung nach Anspruch 3, dadurch gekennzeichnet, daß die Transistoren des Schalters (14, 31) komplementäre Bipolartransistoren sind, die als Komplementär-Emitterfolger geschaltet sind.

7. Schaltungsanordnung nach Anspruch 3, dadurch gekennzeichnet, daß die Transistoren des Schalters komplementäre FET sind, die als Komplementär-Sourcefolger geschaltet sind.

8. Schaltungsanordnung nach Anspruch 1, gekennzeichnet durch die Merkmale:

> Das Differenzierglied weist zwei Kondensatoren (21, 22) auf, deren einer Anschluß mit ein und derselben Klemme (1) des Steuereingangs verbunden ist;
> der anderen Anschluß der Kondensatoren (21, 22) ist mit je einem Basisanschluß zweier zueinander komplementärer dritter und vierter Transistoren (23, 24) verbunden;
> die Primärwicklung ist in zwei gegensinnig gewickelte Teilwicklungen (25, 26) aufgeteilt;
> der Anfang der ersten Teilwicklung (25) ist mit dem Emitter des dritten Transistors (23) verbunden;
> der Anfang der zweiten Teilwicklung (26) ist mit dem Emitter des vierten Transistors (24) verbunden;
> das Ende der ersten Teilwicklung (25) ist mit dem Kollektor des vierten Transistors (24) verbunden;
> das Ende der zweiten Teilwicklung (26) ist mit dem Kollektor des dritten Transistors (23) verbunden.

9. Schaltungsanordnung nach Anspruch 8, dadurch gekennzeichnet, daß die Sekundärwicklung des Übertragers (7) in zwei gegensinnig gewickelte Teilwicklungen (9, 33) aufgeteilt ist, daß jede Teilwicklung über einen Schalter (10) mit einem FET (12, 34) verbunden ist, daß beide FET in Reihe geschaltet sind und daß eine Last (13) zwischen dem Drainanschluß des einen FET (34) beziehungsweise Sourceanschluß des anderen FET (12) einerseits und Masse andererseits liegt.

10. Schaltungsanordnung nach einem der Ansprüche 1 bis 7, dadurch gekennzeichnet, daß die Sekundärwicklung des Übertragers (7) in mindestens zwei gleichsinnig gewickelte Teilwicklungen (9, 19) aufgeteilt ist, daß jede Teilwicklung über einen Schalter (10) mit einem FET (12, 20) verbunden ist, daß die FET in Reihe geschaltet sind und daß eine Last (13) auf der Sourceseite des ersten FET (12) angeordnet ist.

**Claims**

1. A circuit arrangement for driving at least one power-FET (12), with a transformer (7) whose primary winding (8) is connected to a control input (1, 2), with a switch (10) including a diode (11) arranged between the secondary winding (9) and the gate terminal of the FET, where, in the presence of a secondary-side signal of the first polarity the switch connects the gate terminal of the FET (12) to one of the terminals (3) of the secondary winding (9) when the diode becomes transmissive, and in the pressence of a secondary-side signal of the second polarity the switch connects the gate terminal to the source terminal of the FET, characterised in that a differentiator element (5, 6) is arranged between the control input (1, 2) and the primary winding (8).

2. A circuit arrangement as claimed in Claim 1, characterised in that the switch (10) contains a first transistor (14) whose load path is arranged in a manner known per se between the gate terminal and the source terminal of the FET (12), that the switch contains a capacitor (15) whose first terminal is connected to the source terminal of the FET and whose other terminal is connected to the control terminal of the first transistor (14), that the first terminal (3) of the secondary winding (9) is connected via the diode (11) to the gate terminal and via a Zener diode (17) to the control terminal of the first transistor (14), and that the polarity of the Zener diode (17) is such that it is transmissive for the secondary-side signal of the first polarity.

3. A circuit arrangement as claimed in Claim 2, characterised in that the switch contains a further transistor (31) complementary to the first transistor (14), that the load path of the complementary transistor (31) is located between the diode (11) and the gate terminal of the FET and is connected in series with the load path of the first . transistor (14), that the control terminals of the two transistors are connected to one another, and that a further capacitor (32) is provided connected in parallel with the series-connected load paths of the transistors.

4. A circuit arrangement as claimed in Claim 2, characterised in that the first transistor (14) is a bipolar transistor.

5. A circuit arrangement as claimed in Claim 2, characterised in that the first transistor is an FET.

6. A circuit arrangement as claimed in Claim 3, characterised in that the transistors of the switch (14, 31) are complementary bipolar transistors connected as complementary emitter followers.

7. A circuit arrangement as claimed in Claim 3, characterised in that the transistors of the switch are complementary FETs connected as complementary source followers.

8. A circuit arrangement as claimed in Claim 1, characterised by the features:

> the differentiator element possesses two capacitors (21, 22) whose first terminal is connected to one and the same terminal (1) of the control input;
> the other terminal of the capacitors (21, 22) is connected to a base terminal of each of two third and fourth transistors (23, 24) which are mutually complementary;
> the primary winding is divided into two sub-sections (25, 26) wound in opposing fashion;
the start of the first sub-section (25) is connected to the emitter of the third transistor (23);
the start of the second sub-section (26) is connected to the emitter of the fourth transistor (24);
the end of the first sub-section (25) is connected to the collector of the fourth transistor (24); and
the end of the second sub-section (26) is connected to the collector of the third transistor (23).

A circuit arrangement as claimed in Claim 8, characterised in that the secondary winding of the transformer (7) is divided into two sub-sections (9, 33) wound in opposing fashion, that each sub-section is connected via a switch (10) to a FET (12, 34), that the two FETs are connected in series, and that a load (13) is connected to the junction point between the drain terminal of the first FET (34) and the source terminal of the other FET (12) on the one hand, and to earth on the other hand.

10. A circuit arrangement as claimed in one of Claims 1 to 7, characterised in that the secondary winding of the transformer (7) is divided into at least two sub-sections (9, 19) which are wound in the same direction, that each sub-section is connected via a switch (10) to a FET (12, 20), that the FETs are connected in series, and that a load (13) is arranged on the source side of the first FET (12).

**Revendications**

1. Montage pour commander au moins un transistor FET de puissance (12), comportant un transformateur (7) dont l'enroulement primaire (8) est relié à une entrée de commande (1, 2), un commutateur (10) contenant une diode (11) et monté entre l'enroulement secondaire (9) et la borne de grille du transistor FET et qui dans le cas d'un signal présent du côté secondaire et possédant une première polarité, relie la borne de grille du transistor FET (12) à l'une des bornes (3) de l'enroulement secondaire (9), moyennant la mise à l'état passant de la diode, et, dans le cas d'un signal présent du côté secondaire et possédant une seconde polarité, relie la borne de grille à la borne de source du transistor FET, caractérisé par le fait qu'un organe différenciateur, (5, 6) est monté entre l'entrée de commande (1, 2) et l'enroulement primaire (8).

2. Montage suivant la revendication 1, caractérisé par le fait que le commutateur (10) contient un premier transistor (14) dont la voie de charge est située de façon connue en soi entre la borne de grille et la borne de source du transistor FET (12), que le commutateur contient un condensateur (4) dont une borne est reliée à la borne de ce transistor FET et l'autre borne est reliée à la borne de commande du premier transistor (14),

qu'une borne (3) de l'enroulement secondaire (9) est reliée par l'intermédiaire de la diode (11) à la borne de grille et par l'intermédiaire d'une diode Zener (17) à la borne de commande du premier transistor (14), et que la diode Zener (17) est polarisée en sorte qu'elle est passante pour le signal situé du côté secondaire et possédant la première polarité.

3. Montage suivant la revendication 2, caractérisé par le fait que le commutateur contient un autre transistor (31) complémentaire du premier transistor (14), que la voie de charge du transistor complémentaire (31) est située entre la diode (11) et la borne de grille du transistor FET et est branchée en série avec la voie de charge du premier transistor (14), que les bornes de commande des deux transistors sont reliées entre elles et qu'il est prévu un autre condensateur (32) qui est branché en parallèle avec les voies de charge, branchées en série, des transistors.

4. Montage suivant la revendication 2, caractérisé par le fait que le premier transistor (14) est un transistor bipolaire.

5. Montage suivant la revendication 2, caractérisé par le fait que le premier transistor est un transistor FET.

6. Montage suivant la revendication 3, caractérisé par le fait que les transistors (14, 31) du commutateur sont des transistors bipolaires complémentaires qui sont branchés en tant qu'émetteurs suiveurs complémentaires.

7. Montage suivant la revendication 3, caractérisé par le fait que les transistors du commutateur sont des transistors FET complémentaires qui sont branchés en tant que sources suiveuses complémentaires.

8. Montage suivant la revendication 1, caractérisé par les caractéristiques suivantes:

l'organe différenciateur comporte deux condensateurs (21, 22) dont une borne est reliée à la même borne (1) de l'entrée de commande;
l'autre borne des condensateurs (21, 22) est reliée à une borne de base respective de deux transistors formés d'un troisième et d'un quatrième transistors (23, 24) complémentaires entre eux;
l'enroulement primaire est subdivisé en deux enroulements partiels (25, 26) bobinés en sens inverse;
le début du premier enroulement partiel (25) est relié à l'émetteur du troisième transistor (23);
le début du second enroulement partiel (26) est relié à l'émetteur du quatrième transistor (27);
l'extrémité du premier enroulement partiel (25) est reliée au collecteur du quatrième transistor (24);
l'extrémité du second enroulement partiel (26) est reliée au collecteur du troisième transistor (23).

9. Montage suivant la revendication 8, caractérisé par le fait que l'enroulement secondaire du transformateur (7) est subdivisé en deux enroulements partiels (9, 33) bobinés en sens inverse, que chaque enroulement partiel est relié par l'intermédiaire d'un commutateur (10) à un transistor FET (12, 23), que les deux transistors FET sont branchés en série et qu'une charge (13) est disposée entre la borne de drain d'un transistor FET (34) ou la borne de source de l'autre transistor FET (12) d'une part et la masse d'autre part.

10. Montage suivant l'une des revendications 1 à 7, caractérisé par le fait que l'enroulement secondaire du transformateur (7) est subdivisé en au moins deux enroulements partiels (9, 19) bobinés dans le même sens, que chaque enroulement partiel est relié par l'intermédiaire d'un commutateur (10) à un transistor FET (12, 20), que les transistors FET sont branchés en série et qu'une charge (13) est montée du côté source du premier transistor FET (12).

# FIG 1

# FIG 2

# FIG 3

# FIG 4

# FIG 5

# FIG 6